# EUROPEAN PATENT APPLICATION

(11) **EP 1 884 988 A1**
(43) Date of publication of application: **06.02.2008**
(21) Application number: 07014967.9
(22) Date of filing: 31.07.2007
(51) Int. Cl.: H01L 21/285, H01L 21/265

(54) **Method for forming doped metal-semiconductor compound regions**

(30) Priority: 31.07.2006 EP 06118216
(71) Applicant: Interuniversitair Microelektronica Centrum, 3001 Leuven (BE); Koninklijke Philips Electronics N.V., 5621 BA Eindhoven (NL)
(72) Inventor: Pawlak, Bartlomiej Jan, 3001 Leuven (BE); Lauwers, Anne, 2630 Aartselaar (BE)
(74) Representative: Bird, William Edward

(57) **Abstract**

The present invention provides a method for forming doped metal-semiconductor compound regions (14) in a substrate (1). In particular embodiments the present invention provides a method for forming silicide regions (14) in a substrate (1). The method comprises partially regrowing an upper amorphous region (6) on top of a crystalline part (2) of the substrate (1), after having doped the upper amorphous region (6), to form a regrown region (10), thereby leaving a remaining upper amorphous region (7) in between the regrown region (10) and the major surface (4) of the substrate (1). The remaining upper amorphous region (7) is used for forming the metal-semiconductor compound (14).

## Description

### Technical field of the invention

The invention relates to metal-semiconductor compound regions. More particularly, the invention relates to a method for forming doped metal-semiconductor compound regions, for example silicide regions. The doped metal-semiconductor compound regions may form, for example, source and drain regions of a transistor.

### Background of the invention

An important part in the manufacturing process of semiconductor devices is formation of contacts of the semiconductor device, which have further to be bound to back-side device wiring. In particular, a number of approaches to form such contacts are known, which may involve doping a contact region, providing metal on the surface and activating the doping by annealing the semiconductor device at an elevated temperature.

As technology advances, devices become smaller and there is a need for better control over the manufacturing process for forming good contacts. For this reason, lower temperature processes are expected to be used for future generations of semiconductor devices, including in particular next generation CMOS processes.

A particular problem that may arise is that the formation of heavily doped source and drain regions with a dopant concentration of higher than 1x10¹⁴ atoms/cm² or higher than 1x10¹⁵ atoms/cm² by implanting large doses of dopant atoms interferes with the structure of the semiconductor surface or semiconductor/ metal interface. This can cause significant degradation of device performance quality.

One approach to form good junctions and contacts is known as "solid phase epitaxial regrowth" (SPER). WO2005/062352 and WO2005/062354 both describe aspects of such processes. In such processes, the following steps are performed:
- providing a semiconductor substrate;
- carrying out an implantation step to amorphise a top layer of the semiconductor substrate;
- implanting a dopant into the semiconductor substrate to provide the amorphous layer with a predetermined doping profile; and
- annealing the substrate to regrow the amorphous layer and activate the dopant.

The regrowth step improves the quality of the semiconductor substrate and reduces the degrading effect that would otherwise be caused by the dopant implantation step.

Unfortunately, the solution is not complete and there can still be vacancies or interstitials in the semiconductor material, e.g. Si, that can deactivate the junction.

Another, particular approach that may be used to provide good contacts is the use of silicides such as NiSi to form contact junctions. A known problem with this approach is that NiSi "stingers" may be formed. These are NiSi extensions extending from the metal silicide regions into extension regions and possibly into a channel region, thereby causing a short circuit of the P-N junction and thus preventing correct transistor function or at least significantly reducing transistor performance.

WO2004/042809 describes a process for forming NiSi contacts that is said to reduce such stingers using a SPER process. Therefore, Xenon ions are implanted at a suitable dose and while the substrate is at an elevated temperature to amorphise a region of the semiconductor with a thickness of between 50 and 200 nm at the surface of the semiconductor. Then, processing continues with formation of extension regions. This is done with a first implantation step and may be followed by a subsequent second implantation step for forming heavily doped source and drain regions. A recrystallisation step is then carried out which recrystallises the amorphous regions to form crystalline regions with good quality. Ni is then deposited and NiSi is formed in a subsequent annealing cycle.

The implantation steps forming the extension source and drain regions, and in particular, the steps forming heavily doped source and drain regions, inevitably damage the crystal structure. This damage gives rise to the "stingers". In the process described, the recrystallisation step improves the quality of the amorphous regions. According to WO2004/042809, this reduces the number of silicide "stingers" when the NiSi is formed.

Further experiments with low temperature processes show that there can be problems both with high source and drain resistance and also with current leakage. In order to obtain suitable resistances for source and drain contacts of lower than 500 Ohm or lower than 300 Ohm, depending on the size of the contacts, the processing temperature may need to be higher than would otherwise be preferred. Accordingly, there is a need for improved methods addressing these issues.

### Summary of the invention

It is an object of embodiments of the present invention to provide a method for manufacturing doped metal-semiconductor compound regions, e.g. silicide regions.

The above objective is accomplished by a method and device according to the present invention.

In a first aspect, the present invention provides a method for forming doped metal-semiconductor compound regions. The method comprises:
- providing a semiconductor substrate comprising an upper amorphous region above a crystalline region separated by an interface, the semiconductor substrate having a major surface,
- doping the upper amorphous region,
- regrowing the upper amorphous region, and
- forming a metal-semiconductor compound of part of the upper amorphous region to form metal-semiconductor compound regions.
Regrowing the upper amorphous region is performed by partially regrowing the upper amorphous region to form a regrown region on the interface, thereby leaving a remaining upper amorphous region in between the regrown region and the major surface of the substrate. Forming a metal-semiconductor compound is performed using the remaining upper amorphous region.

In this first aspect, the present invention provides a method for forming doped silicide regions. The method comprises:
- providing a semiconductor substrate comprising an upper amorphous region above a crystalline silicon region separated by an interface, the semiconductor substrate having a major surface,
- doping the upper amorphous region,
- regrowing the upper amorphous region, and
- silicidizing part of the upper amorphous region to form metal silicide regions.
Regrowing the upper amorphous region is performed by partially regrowing the upper amorphous region to form a regrown region on the interface, thereby leaving a remaining upper amorphous region in between the regrown region and the major surface of the substrate. Silicidizing part of the upper amorphous region is performed using by silicidizing the remaining upper amorphous region.

The method according to embodiments of the invention is easy to integrate into conventional semiconductor processing, which is an advantage.

By only partially regrowing the semiconductor substrate, contacts may be formed with improved properties. For example, improved, low contact of between 170 Ohm and 200 Ohm and low current leakage of lower than 1x10⁻⁸ A, e.g. between 4x10⁻⁹ A and 1x10⁻⁸ A, can be obtained with a low thermal budget. This is in contrast with prior SPER processes where the amorphous region is completely regrown which leads to an increased thermal budget, and which may damage other regions of a semiconductor device.

Formation of metal-semiconductor compounds, e.g. silicide, is slightly faster on amorphous semiconductor material than on crystalline material, so a lower thermal budget is needed than for prior art SPER processes. Furthermore, the crystalline/amorphous interface acts as a barrier limiting growth of the silicide resulting in a good abrupt interface. Unlike the prior art, the growth of the silicide in the amorphous layer substantially prevents injection of interstitial vacancies that can deactivate the junction in the prior art.

Partially regrowing the upper amorphous region may be performed by annealing at a temperature below 600°C. For example, according to embodiments of the invention, annealing may be performed at a temperature of between 520°C and 580°C for a time period of between 15 s and 45 s. According to other embodiments of the invention, annealing may be performed at a temperature of between 470°C and 530°C for a time period of between 40 s and 300 s. Alternatively, slightly longer anneal times may be used at slightly lower temperatures. For example, annealing may be performed at a temperature of between 470°C and 530°C for a time period of between 40 s and 400 s, in particular between 60 s and 300 s.

According to particular embodiments of the invention, the metal layer may comprise Ni and the metal silicide may comprise NiSi.

Forming a metal-semiconductor compound of the remaining upper amorphous region, e.g. silicidizing the remaining upper amorphous region, may be performed by:
- depositing a metal layer on the remaining upper amorphous region, and
- making the metal layer react with the remaining upper amorphous region to form the metal-semiconductor compound, e.g. metal silicide.

Providing a semiconductor substrate comprising an upper amorphous region above a crystalline silicon region separated by an interface may be performed by:
- providing a substrate having at least a crystalline region, and
- amorphising an upper region of the crystalline semiconductor substrate to form upper amorphous region.

Amorphizing an upper region of the crystalline silicon region may be performed such that the upper amorphous region has a thickness of between 20 nm and 80 nm, in particular between 30 nm and 60 nm.

Amorphizing an upper region of the crystalline semiconductor substrate may be performed by implantation of dopant atoms. Implantation of dopant atoms may be performed at an energy of between 15 keV and 40 keV at a dose of between 2x10¹⁴ atoms/cm² and 3x10¹⁵ atoms/cm². Implantation of dopant atoms may for example comprise implanting Ge atoms.

Doping the upper amorphous region may be performed at an energy of between 5 keV and 10 keV at a dose of between 1x10¹⁵ atoms/cm² and 5x10¹⁵ atoms/cm². Doping the upper amorphous region may be performed by implanting boron.

According to an embodiment of the invention the method may comprise:
- providing a crystalline semiconductor substrate, e.g. a crystalline silicon substrate;
- rendering the top of the semiconductor substrate amorphous to form an upper amorphous region above a crystalline region;
- implanting dopants in the upper amorphous region to dope the upper amorphous region;
- partially regrowing the upper amorphous region from the crystalline region to form a regrown region above the crystalline region leaving a remaining upper amorphous region above the regrown region;
- depositing metal on the remaining upper amorphous region; and
- reacting the metal with the remaining upper amorphous region to form a metal-semiconductor compound, e.g. metal silicide.

In a further aspect, the present invention provides a method for manufacturing a transistor device. The method comprises forming doped metal-semiconductor compound regions, e.g. silicide regions, according to any of the previous claims. The method may furthermore comprise steps of providing a first and a second main contact and a control contact.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Figures 1 to 3 show side views of subsequent steps in a method according to embodiments of the invention.
Figure 4 shows a side view of an embodiment of a CMOS transistor made with the method according to embodiments of the invention.
Figure 5 shows a graph illustrating contact resistance for contacts formed by conventional methods (curves 40 and 42) and for contacts formed with a method according to embodiments of the invention (curves 44 and 46).
Figure 6 shows a graph illustrating leakage current for contacts formed by conventional methods (curves 40 and 42) and for contacts formed with the method according to embodiments of the invention (curves 44 and 46).

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, over and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practised without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

Reference will be made to transistors. These are three-terminal devices having a first main electrode such as a drain, a second main electrode such as a source and a control electrode such as a gate for controlling the flow of electrical charges between the first and second main electrodes.

It will be clear for a person skilled in the art that the present invention is also applicable to similar devices that can be configured in any transistor technology, including for example, but not limited thereto, CMOS, BICMOS, Bipolar and SiGe BICMOS technology.

The present invention provides a method for forming doped metal-semiconductor compound regions. The method comprises:
- providing a semiconductor substrate comprising an upper amorphous region above a crystalline region separated by an interface, the semiconductor substrate having a major surface,
- doping the upper amorphous region,
- regrowing the upper amorphous region, and
- forming a metal-semiconductor compound of part of the upper amorphous region,
wherein regrowing the upper amorphous region is performed by partially regrowing the upper amorphous region to form a regrown region on the interface, thereby leaving a remaining upper amorphous region in between the regrown region and the major surface of the substrate, and forming a metal-semiconductor compound of part of the upper amorphous region is performed by forming a metal-semiconductor compound of the remaining upper amorphous region.

The method according to embodiments of the invention is easy to integrate into conventional processing, which is an advantage.

With the method according to embodiments of the invention contacts can be formed having a low contact resistance of between 170 Ohm and 200 Ohm and low leakage current of between 4x10⁻⁹ A and 1x10⁻⁸ A.

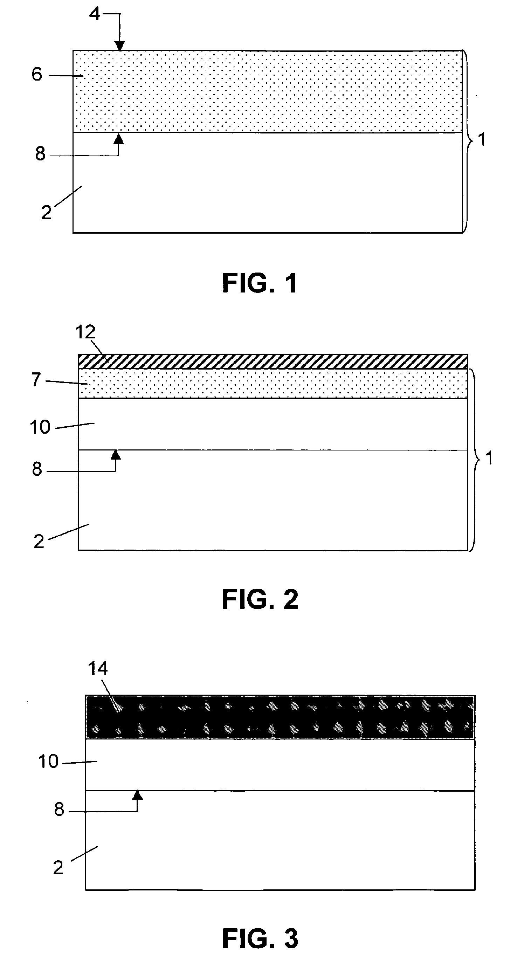

Hereinafter, the method according to the invention will be described by means of Figures 1 to 3. These figures illustrate subsequent steps in the method according to embodiments of the invention. It has to be understood that the description hereinafter is only for the purpose of explaining the invention and is not intended to limit the invention in any way. The method according to embodiments of the invention may also comprise a different sequence of steps, may comprise additional steps or may use other materials. The present invention is thus not limited to the steps or materials described.

Furthermore, the present invention will be described by means of silicon as a material the crystalline region is formed of. In this particular case forming a metal-semiconductor compound comprises forming a silicide. This step is called silicidation. However, the present invention may also be applied to any semiconductor material, suitable for thermally reacting with metal to form a metal-semiconductor compound, such as SiGe or Ge semiconductor layers, which respectively form germanosilicide and germanide upon thermal reaction with a metal. Again, the above examples are not intended to limit the invention in any way.

According to embodiments of the invention, a method is provided for forming doped silicide regions. The method comprises:
- providing a semiconductor substrate comprising an upper amorphous region above a crystalline silicon region separated by an interface, the semiconductor substrate having a major surface,
- doping the upper amorphous region,
- regrowing the upper amorphous region, and
- silicidizing part of the upper amorphous region,
wherein regrowing the upper amorphous region is performed by partially regrowing the upper amorphous region to form a regrown region on the interface, thereby leaving a remaining upper amorphous region in between the regrown region and the major surface of the substrate, and wherein silicidizing part of the upper amorphous region is performed by silicidizing the remaining upper amorphous region.

In a first step, a substrate 1 is provided having a major surface 4 and having an upper crystalline Si region 2. In embodiments of the present invention, the term "substrate" may include any underlying material or materials that may be used, or upon which a device, a circuit or an epitaxial layer may be formed. In other alternative embodiments, this "substrate" may include a semiconductor substrate such as e.g. doped silicon, a gallium arsenide (GaAs), a gallium arsenide phosphide (GaAsP), an indium phosphide (InP), a germanium (Ge), or a silicon germanium (SiGe) substrate. The "substrate" may include for example, an insulating layer such as a SiO₂ or a Si₃N₄ layer in addition to a semiconductor substrate portion. Thus, the term substrate also includes silicon-on-glass, silicon-on sapphire substrates. The term "substrate" is thus used to define generally the elements for layers that underlie a layer or portions of interest. Also, the "substrate" may be any other base on which a layer is formed, for example a glass or metal layer. A substrate according to embodiments of the present invention has an upper crystalline semiconductor region, e.g. crystalline Si region 2.

An upper part of the crystalline silicon region 2, i.e. a part of the crystalline silicon region 2 from the major surface 4 in a direction down to the bulk of the substrate 1, is then amorphised to form an upper amorphous region 6. The upper amorphous region 6 may have a thickness of between 20 nm and 80 nm, in particular between 30 nm to 60 nm. Amorphizing part of the crystalline silicon region 2 may be performed by implanting dopant atoms, such as e.g. Ge, Xe, Ar or He at an energy of between 15 keV and 40 keV and with a dose of between 2x10¹⁴ atoms/cm² and 3x10¹⁵ atoms/cm² (= between 2x10¹⁸ atoms/m⁻² and 3x10¹⁹ atoms/m⁻²). The implantation can be carried out by an ion implantation apparatus as is known in the art. The structure obtained after amorphising part of the crystalline silicon region 2 is illustrated in Figure 1. The structure comprises a crystalline silicon region 2 above an upper amorphous region 6, both regions 2, 6 being separated from each other by an interface 8.

For the purpose of clarity, in Figure 1 only an upper part of the substrate 1 is shown, i.e. that part of the substrate 1 comprising the crystalline Si region 2 and the upper amorphous region 6. Other substrate layers may be present underneath the crystalline Si region 2.

Next, the upper amorphous region 6 may be doped. This may be done by, for example, implantation of boron or of any other suitable dopant known by a person skilled in the art. Implantation of dopants may be done at an implantation energy of between 5 keV and 10 keV with a dose of between 1x10¹⁵ atoms/cm² and 5x10¹⁵ atoms/cm² (= 1x10¹⁹ atoms/m⁻² to 5x10¹⁹ atoms/m⁻²).

In a next step, partial regrowth, also referred to as partial recrystallisation, of the upper amorphous region 6 may be performed to form a regrown region 10 on the interface 8, thereby leaving a remaining upper amorphous region 7 in between the regrown region 10 and the major surface 4 of the substrate 1. Regrowth occurs starting from interface 8 between the crystalline region 2 and the amorphous region 6. Partial regrowth may be performed by a low temperature anneal. The temperature of the anneal and the time of the anneal are inversely related. Partial regrowth may be performed at a temperature below 600°C. According to embodiments of the invention, partial regrowth may be performed at a temperature between 520°C and 580°C for a time period between 15 s and 45 s. According to other embodiments of the invention, partial regrowth may be performed at a temperature between 470°C and 530°C for a time period between 40 s and 300 s. For example, partial regrowth may be performed at a temperature of 550°C during a time period between 20 seconds and 40 seconds, or at a temperature of 500°C during a time period between 1 minute and 5 minutes. As will be appreciated by a person skilled in the art, the above features are only examples and intermediate or lower temperatures with corresponding time periods may also be used. For example, slightly longer anneal times may be used at slightly lower temperatures. For example, annealing may be performed at a temperature between 470°C and 530°C for a time period between 40 s and 400 s, in particular between 60 s to 300 s.

An important feature of the method according to embodiments of the invention is that regrowth or recrystallisation of the upper amorphous region 6 is only partial. This means that annealing is not carried out long enough to regrow the complete upper amorphous region 6, but only part of it is regrown, thereby forming regrown region 10 above the crystalline silicon region 2 and leaving a remaining part 7 of the upper amorphous region 6 above the regrown region 10, or, in other words, in between the regrown region 10 and the major surface 4 of the substrate 1. For example, the remaining part 7 of the upper amorphous region 6 may have a thickness of between 15 nm and 30 nm.

By only partially regrowing the semiconductor, contacts may be formed with improved properties. For example, improved, low contact of between 170 Ohm and 200 Ohm and low current leakage of lower than 1x10⁻⁸ A can be obtained with a low thermal budget. This is in contrast with prior SPER processes where the amorphous region is completely regrown which leads to an increased thermal budget, and which may damage other regions of a semiconductor device.

Formation of metal-semiconductor compounds, e.g. silicide, is slightly faster on amorphous semiconductor material than on crystalline material, so a lower thermal budget is needed than for prior art SPER processes. Secondly, the crystalline/amorphous interface acts as a barrier limiting growth of the silicide resulting in a good abrupt interface. Unlike the prior art, the growth of the silicide in the amorphous layer substantially prevents injection of interstitial vacancies that can deactivate the junction in the prior art.

In a next step, a metal layer 12 is deposited over the major surface 4 of the substrate 1. This is illustrated in Figure 2. The metal layer 12 may, for example, have a thickness of between 10 nm and 50 nm or between 15 nm and 30 nm. The metal layer 12 may comprise any suitable metal able to form, upon heating, a metal-semiconductor compound, e.g. a silicide, by reaction with the semiconductor material, e.g. silicon, of the remaining part 7 of the upper amorphous region 6. For example, the metal layer 12 may comprise Ni, Ti, Pt or any other suitable metal. According to embodiments of the invention, the metal layer 12 may comprise nickel.

Finally, silicidation is carried out to form metal silicide 14. This may, for example, be performed at a temperature of between 300°C and 350°C at which the metal layer 12 reacts with the remaining part 7 of the upper amorphous region 6 to form a metal silicide layer 14, as illustrated in Figure 3. According to embodiments of the invention, the silicide may be nickel silicide.

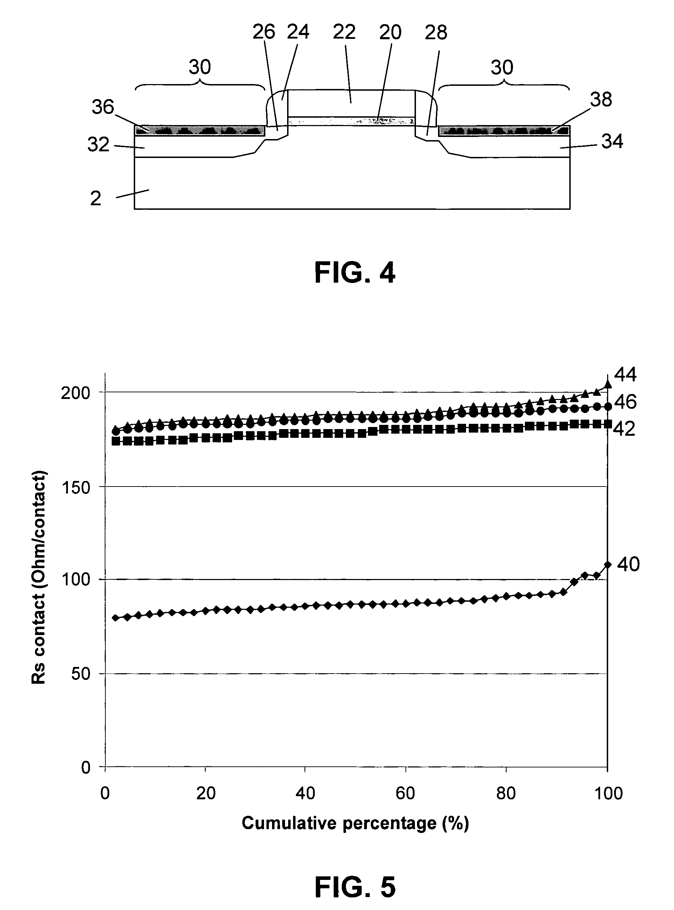

The method according to embodiments of the invention may, for example, be used to form metal silicide contacts, e.g. NiSi contacts 36, 38 in transistors. Any suitable method known by a person skilled in the art for making transistors may be used. For example, a gate dielectric 20 and a gate 22 may be formed followed by formation of source extension 26 and drain extension 28. Spacers 24 may be formed at sidewalls of the gate 22 (see Figure 4).

Doped regions 30 may then be formed in the crystalline region 2 of the substrate 1 at locations adjacent to the spacers 24 using the method according to embodiments of the invention and as for example illustrated in Figures 1 to 3. Therefore, an upper part of the crystalline silicon region 2, i.e. part of the crystalline silicon region 2 from the major surface 4 in a direction down to the bulk of the substrate 1, is amorphised to form an upper amorphous region 6. The upper amorphous region 6 may have a thickness of between 20 nm and 80 nm, in particular between 30 nm and 60 nm. Dopants, e.g. boron, may then be implanted into the upper amorphous regions 6 as set out above. Then, partial regrowth, also referred to as partial recrystallisation, is carried out to partially recrystallise the amorphous regions 6 to form the doped source region 32, e.g. heavily doped source regions with a dopant concentration of higher than 1x10¹⁴ atoms/cm² or higher than 1x10¹⁵ atoms/cm² , and doped drain region 34, e.g. heavily doped drain region with a dopant concentration of higher than 1x10¹⁴ atoms/cm² or higher than 1x10¹⁵ atoms/cm², as regrown regions 10, leaving remaining parts 7 of the amorphous regions 6 above them.

A metal layer, e.g. Ni layer 12, is then deposited onto the major surface 4 of the substrate 1 in regions 30 and is silicidized, i.e. it is reacted with the remaining parts 7 of the amorphous regions 6 to form the NiSi source contact regions 36 and NiSi drain contact regions 38 by performing an anneal step at a temperature of between 300°C and 350°C.

It has to be noted that the method according to embodiments of the invention is easy to integrate into conventional processing and which is an advantage.

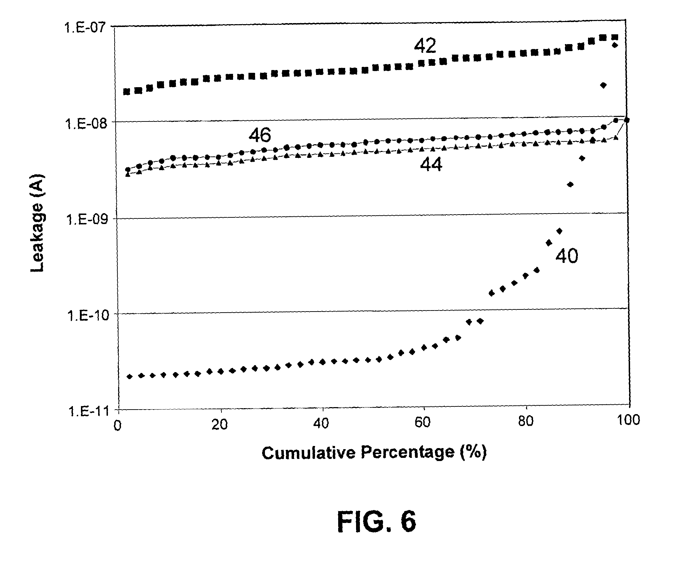

Figures 5 and 6 illustrate the improvement obtained with methods according to embodiments of the present invention. Four samples were prepared and measured. Measurement results are illustrated in Figures 5 and 6. The x-axis represents the cumulative percentage of a number of samples formed according to a same method. Thus, a horizontal line represents very similar properties in all samples whereas a substantial vertical variation represents a substantial intersample variation.

For a first sample, indicated in Figures 5 and 6 as a curve marked with diamonds (curve 40), contacts were formed according to a conventional method with spike doping and an anneal step at 1050°C. For a second sample, indicated in Figures 5 and 6 as a curve marked with squares (curve 42), contacts were formed by Solid Phase Epitaxial Regrowth (SPER) and annealed at 650°C for one minute to fully regrow the amorphous layer. For the third and fourth sample contacts were formed with a method according to embodiments of the invention. For the third sample, indicated in Figures 5 and 6 as a curve marked with triangles (curve 44), the substrate 1 was annealed at 550 °C for 30s and for the fourth sample, indicated in Figures 5 and 6 as a curve marked with circles (curve 46), the substrate 1 was annealed at 550 °C for 40s. Inspection of the fourth sample using a transmission electromicrograph reveals a NiSi layer 14 with a thickness of about 20 nm above a regrown layer 10 with a thickness of about 25 nm.

Figure 5 illustrates the contact resistance for the different contacts. Similar contact resistances of between 170 Ohm and 200 Ohm were obtained for the second, third and fourth sample, in spite of the much lower thermal budget (lower temperature and shorter time) required for the third and fourth samples formed according to embodiments of the invention compared to sample formed according to methods of the prior art. For the first sample, a much lower contact resistance was obtained, but there a much higher thermal budget has been used than for forming the samples according to embodiments of the present invention.

The real benefit may be seen in Figure 6 where the samples formed with the method according to embodiments of the invention clearly show a low leakage current of between 5x10⁻⁹ A and 1x10⁻⁸ A, which is a full order of magnitude lower than the leakage current of the second sample.

The method according to embodiments of the invention may be applied to a wide range of transistor types, including conventional transistors. The invention may in particular be applied to both n-type and p-type transistors.

Furthermore, the detailed process parameters set out above may be varied as required in any particular application.

The method according to embodiments of the invention may also be of particular benefit in any advanced transistor for which the avoidance of excess thermal heating to form the contacts is important.

The method according to embodiments of the invention may in particular be used for advanced CMOS technology transistors using strained silicon for enhancing the carrier mobility.

It is to be understood that although preferred embodiments, specific constructions and configurations, as well as materials, have been discussed herein for devices according to the present invention, various changes or modifications in form and detail may be made without departing from the scope of this invention as defined by the appended claims.

## Claims

1. A method for forming doped silicide regions (14), the method comprising:
- providing a semiconductor substrate (1) comprising an upper amorphous region (6) above a crystalline silicon region (2) separated by an interface (8), the semiconductor substrate (1) having a major surface (4),
- doping the upper amorphous region (6),
- regrowing the upper amorphous region (6), and
- silicidizing part of the upper amorphous region to form metal silicide regions (14),
wherein regrowing the upper amorphous region (6) is performed by partially regrowing the upper amorphous region (6) to form a regrown region (10) on the interface (8), thereby leaving a remaining upper amorphous region (7) in between the regrown region (10) and the major surface (4) of the substrate (1), and wherein silicidizing part of the upper amorphous region is performed by silicidizing the remaining upper amorphous region (7).

2. Method according to claim 1, wherein silicidizing the remaining upper amorphous region (7) is performed by:
- depositing a metal layer (12) on the remaining upper amorphous region (7), and
- reacting the metal layer (12) with the remaining upper amorphous region (7) to form metal silicide (14).

3. Method according to claim 1 or 2, wherein providing a semiconductor substrate (1) comprising an upper amorphous region (6) above a crystalline silicon region (2) is performed by:
- providing a substrate (1) having at least a crystalline region (2), and
- amorphising an upper region of the crystalline semiconductor substrate (2) to form upper amorphous region (6).

4. Method according to any of the previous claims, wherein partially regrowing the upper amorphous region (6) is performed by annealing at a temperature below 600°C.

5. Method according to claim 4, wherein annealing is performed at a temperature between 520°C and 580°C for a time period between 15 s and 45 s.

6. Method according to claim 4, wherein annealing is performed at a temperature between 470°C and 530°C for a time period between 40 s and 300 s.

7. Method according to any claims 2 to 6, wherein the metal layer (12) comprises Ni and the metal silicide (14) comprises NiSi.

8. Method according to any of claims 3 to 7, wherein amorphizing an upper region of the crystalline semiconductor substrate (2) is performed by implantation of dopant atoms.

9. Method according to any of claims 3 to 8, wherein amorphizing an upper region of the crystalline silicon region (2) is performed such that the upper amorphous region (6) has a thickness of between 20 nm and 80 nm.

10. Method according to claim 8 or 9, wherein implantation of dopant atoms is performed by implanting Ge atoms.

11. Method according to any of claims 8 to 10, wherein implantation of dopant atoms is performed at an energy of between 15 keV and 40 keV at a dose of between 2x10¹⁴ atoms/cm² and 3x10¹⁵ atoms/cm².

12. Method according to any of the previous claims, wherein doping the upper amorphous region (6) is performed by implanting boron.

13. Method according to any of the previous claims, wherein doping the upper amorphous region (6) is performed at an energy of between 5 keV and 10 keV at a dose of between 1x10¹⁵ atoms/cm² and 5x10¹⁵ atoms/cm².

14. A method for forming doped metal-semiconductor compound regions (14), the method comprising:
- providing a semiconductor substrate (1) comprising an upper amorphous region (6) above a crystalline region (2) separated by an interface (8), the semiconductor substrate (1) having a major surface,
- doping the upper amorphous region (6),
- regrowing the upper amorphous region (6), and
- forming a metal-semiconductor compound (14) of part of the upper amorphous region to form metal-semiconductor compound regions (14),
wherein regrowing the upper amorphous region (6) is performed by partially regrowing the upper amorphous region (6) to form a regrown region (10) on the interface (8), thereby leaving a remaining upper amorphous region (7) in between the regrown region (10) and the major surface (4) of the substrate (1), and wherein forming a metal-semiconductor compound (14) of part of the amorphous region is performed by forming a metal-semiconductor compound (14) of the remaining upper amorphous region (7).

15. A method for manufacturing a transistor device, comprising forming doped metal-semiconductor compound regions according to any of the previous claims.
